# EUROPEAN PATENT APPLICATION

(11) **EP 0 742 585 A1**
(43) Date of publication of application: **13.11.1996**
(21) Application number: 96107099.2
(22) Date of filing: 06.05.1996
(51) Int. Cl.: H01L 21/32, H05K 3/06, B41M 1/12, B44C 1/22

(54) **Method and compositions for diffusion patterning tape on substrate**

(30) Priority: 08.05.1995 US 435076
(71) Applicant: E.I. DU PONT DE NEMOURS AND COMPANY, Wilmington Delaware 19898 (US)
(72) Inventor: Felten, John James, Chapel Hill, North Carolina 27516 (US)
(74) Representative: von Kreisler, Alek, Dipl.-Chem.

(57) **Abstract**

A method for making patterns in organic polymer layers comprising the sequential steps:
A. Applying by lamination to a substrate an unpatterned first layer comprising a polymeric tape;
B. Applying to the unpatterned first layer a patterned second layer comprising a liquid solution consisting of organic acid or base and plasticizer;
C. Heating the patterned second layer to effect penetration of the organic acid or base and plasticizer into the underlying areas of the first layer whereby the polymeric film in the underlying areas of the first layer becomes solubilized by reaction with the organic acid or base; and
D. Washing the layers with water or an aqueous solution to remove the solubilized polymer from patterned areas of the first layer.

## Description

### FIELD OF THE INVENTION

The invention is directed to a method for diffusion patterning of organic polymer tapes and to polymeric tape compositions which are especially suitable for patterning by that method.

### BACKGROUND OF THE INVENTION

The advantages of using ceramic dielectrics in tape form are well known, and are the subject of numerous patents. The advantages include lower defect counts than in screen printed dielectrics, thicker coatings than can be screen printed, and the ability to inspect films before they are laminated.

A major disadvantage of dielectrics in tape form is the need to mechanically punch vias and other features into the tape. Compared to production of vias by diffusion patterning or by screen printing, the process is slow. Screen printed vias can be produced at a sustained rate of 2,000 per second, and diffusion patterning techniques can substain over 10,000 vias per second. Typical via punching rates, however, are only about ten vias per second. Another disadvantage is that tapes must be stripped from their backing during processing, which subjects the tape to forces than can distort the tape. The fragile tape must be accurately registered before laminating. Also, current press lamination equipment tends to be quite expensive, when it is compared to roll lamination equipment.

Clearly, a much faster, less expensive way to produce vias is necessary in order to competitively produce interconnets with 10,000 to 100,000 vias per layer, and, typically, and 2 to 5 dielectric layers in a multichip interconnect. Additionally, a tape that is capable of being laminated in a roller apparatus than in a press will permit much higher throughput and productivity than current lamination schemes.

In addition, processes that require etch, photoresists or plating are lengthy, process sensitive and expensive. Furthermore, some of the processes use solvents that are difficult to handle. Accordingly, the need continues for a fast, environmentally safe method for making high resolution images in organic polymer tapes, and particularly in thick films, that avoids the problems mentioned above.

### SUMMARY OF THE INVENTION

The invention is directed to a method for making patterns in organic polymer layers comprising the sequential steps:
A. Applying by lamination to a substrate an unpatterned first layer comprising a polymeric tape;
B. Applying to the unpatterned first layer a patterned second layer comprising a liquid solution consisting of organic acid cr base and plasticizer;
C. Heating the patterned second layer to effect penetration of the organic acid or base and plasticizer into the underlying areas of the first layer whereby the polymeric film in the underlying areas of the first layer becomes solubilized by reaction with the organic acid or base; and
D. Washing the layers with water or an aqueous solution to remove the solubilized polymer from patterned areas of the first layer.

The invention is further directed to a polymeric tape composition for use as the unpatterned first layer in a diffusion patterning process comprising:
A. a film-forming soluble or dispersible polymer;
B. a plasticizer in which the polymer is completely or partially soluble; and
C. volatile organic solvent.

### BRIEF DESCRIPTION OF THE DRAWINGS

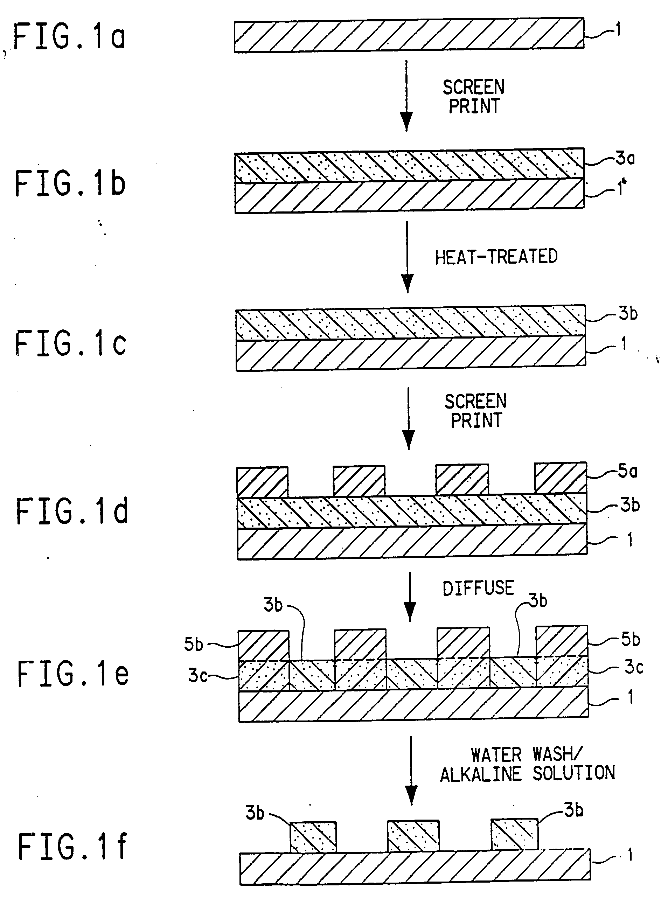

Figure 1 (a-f) illustrates schematically the separate steps of the invention when is used to pattern a polymeric film in tape form.

### DETAILED DESCRIPTION OF THE INVENTION

It has been found that a tape of as much as 100 microns thickness can be diffusion patterned with vias of ten to twelve mils diameter.

The present invention poses several findings about formulation and lamination of diffusion patternable tapes:
* The formulation is different from standard tape on substrate (TOS), because the diffusion patterning (DP) TOS never needs to support itself. It is always either supported on Mylar backing or on a ceramic substrate.
* Because of the lesser strength needed, a softer, more pliable tape is preferred then that that is presently made to yield and flow under pressure. This softer, more pliable tape will reduce the height of humps produced by buried lines and other raised features. This feature is highly desirable in multilayer applications. This also permits roll lamination to be used instead of press lamination.
* Because of the high solids level of the filled dielectric tapes, they have a yield point. The tapes will not flow until they are subject to pressure in excess of their yield point. Therefore, they are less prone to creep when kept in a roll for storage. Standard tapes such as commonly used photoresists are not highly filled and are more subject to creep.
* The extra pliability of DP TOS compared to press laminatable tape can also be taken advantage of to make tapes that are roll laminatable. Roll laminatable tapes permit much higher production rates and simplifies the process where only one or two layers of tape are used.
* To optimize the resolution of vias, it has been found that two prints of imaging paste (patterned layer) can be used: one beneath the laminated tape, and one on top. That way, diffusion proceeds from top and bottom simultaneously and meets in the middle.
* The organic portion of the diffusion patterning tape may consist of two phases; one resin rich, to provide strength and hardness, and one high in plasticizer content, which aids in the diffusion of the basic or acidic patterning ink into the tape. Diffusion in the aqueous tapes appears slower and to a lesser depth using a single phase formulation than with the two phase formulation. It may be desirable to add a second resin in small amounts that is incompatible with the primary resin, and that will substantially raise the viscosity of the plasticizer rich phase and prevent plasticizer from being expressed by the tape when it is subjected to high temperature and pressure.

In the tape compositions of the present invention, the preferred tapes are formulated so that they can be laminated to the substrate and pressed together by using a heated, pressurized roll. The formulations of the present invention requires a higher level of organic content than compositions currently used in press-laminated processes. The usual approach as known to those skilled in the art is to formulate tapes with maximum practical amounts of plasticizer which minimizes the amount of matter that must be burned out in a furnace.

The solids level (inorganic fraction) of the tape is constrained by the necessity to completely surround the inorganic phase with the vehicle (organic fraction) of the tape; additionally, sufficient vehicle must exist at the surface of the tape so it will act as an adhesive to the substrate, or the layer of tape beneath, at low temperature and pressure, when said temperature and pressure are applied for only a few seconds. The type of inorganic fraction is determined by the type of ceramic or metal layer needed in a given application, and its formula will be determined by the electrical and structural needs of the particular application. The organic fraction, or "vehicle", is designed to optimize the ability to apply and pattern the tape, to meet the needs of a given type of application.

### A. Definitions

As used herein the following terms have the indicated meanings:

The term "dispersible" means an apparently homogeneous composition which consists of a microscopically heterogeneous mixture of two or more finely didvided phases.

The term soluble means capable of mixing with a liquid to form a homogeneous mixture.

The term "volatile solvent" refers to liquid organic solvents which can be removed from the unpatterned first layer by heating to 120 degrees C or less at atmospheric pressure.

The term "non-crystalline polymers" refers to solid organic polymers having no more than about 50% crystallinity.

The term "acid labile group" refers to a labile group which is rendered nonreactive to aqueous bases by the protection of an associated functional moiety, which moiety is readily removable by reaction with acids, thus deprotecting the labile group and rendering it amenable to reaction with aqueous bases. In the case of this invention, the acid labile group is an alcohol that is easily hydrolyzed off the polymer, creating an acidic resin that can then be dispersed using an alkaline aqueous eluant.

The term "acid labile polymer" refers to an aqueous base-insoluble solid organic polymer which contains a plurality of acid labile groups which are either in the backbone of the polymer directly or indirectly pendantly attached along the polymer backbone in sufficient number to render the polymer soluble in dilute aqueous base solutions or water when the protective moieties are removed from the acid labile groups by reaction with acids. Polymer cross-linked with acid labile groups can also be used.

The term "solvent free" refers to compositions from which volatile solvent has been removed substantially completely, i.e., any residual amount of solvent is less than about 1% by weight of the remaining composition.

The term "acrylates and "acrylics" as used herein to describe monomers and polymers include methacrylates as well as acrylates.

All proportions are by weight% unless otherwise indicated.

### B. Detailed description of the Drawing

The diffusion patterning process may more easily be appreciated by reference to the Figure, which illustrates schematically the separate steps of the process as it is applied to the patterning of a polymeric film in tape form.

A layer of dielectric tape on substrate (3a) is applied by roll lamination onto an alumina substrate (1). The dielectric tape may contain finely divided particles of glass and inorganic oxides dispersed in an organic medium comprising a polymer dissolved in a suitable plasticizer. Further, the tape is usually supported by a backing, such as Mylar® or the like. Prior to lamination of the tape on the substrate, the backing is stripped from the tape. After laminating the layer 3a, the laminated tape is heated optionally at up to 100°C in an oven for a period of about 10 minutes to improve adhesion.

A patterned second layer 5a is screen printed over the tape on substrate dielectric film layer 3b. The second layer is a fluid solution comprised of an alkaline or acidic sensitizer, such as p-toluene sulfonic acid or triethanolamine, in a plasticizer such as dibutylphthalate or butyl benzyl phthalate, with one or more resins such as ethyl cellulose, and terpineol as solvent. If tape containing an acid labile polymer is being patterned the sensitizer is acidic. If an acid containing resin is used, the sensitizer is alkaline, as triethanolamine. Upon forming the patterned layer 5b, the assemblage is oven heated, during which the sensitizing acid or base and plasticizer are diffused into the underlying areas of thick film dielectric layer 3b reacting with the free acid in the polymer or if acid labile hydrolyzing the weakly bonded ester groups in the polymer thus creating free acid groups The free acid groups are necessary for washing out the tape (3c).

Thereby the sensitizer reacts with the solubilizing groups of the polymer to render it dispersible in water or alkaline solution. Since ethyl cellulose is not significantly soluble in the plasticizer, the remaining patterning print components do not form a strong film, and are easily washed away by a water or alkaline spray which is used to develop the pattern beneath it.

The patterned layer 5b consists mainly of solubilized resin, plasticizer, and optionally residual acid, plus inorganic solids. It is washed with water or an alkaline solution at an appropriate pH, to remove the underlying diffusion patterned layer 5b. Upon completion of the washing, the surface of substrate 1 is exposed in the areas which underlay the pattern of layer 3c and a very precise negative image 3(b) of the pattern remains in the tape from which it was washed.

### C. Substrate

The method of the invention can be used on either inorganic substrates, such as A1₂0₃, SiO₂, silicon, AlN and the like, or organic substrates, such as, phenoxy resins, epoxy resins and the like, or composite substrates such as filled organic polymers, or on other previously patterned layers of TOS similar to itself.

### D. Polymer

A characteristic of both polymer layers is that the polymers should be substantially soluble or dispersible in an appropriate solvent or plasticizer. The solubility or dispersibility of the polymer is desirable in order to facilitate the diffusion of a solubility adjusting agent in a patterned second layer into a unpatterned polymer tape. In contrast, an addition of a platinum catalyst, for example, without solubility and non-dispersibility can cause thermally induced selective volatilization of a non-soluble or non-dispersible polymer. However, the preferred polymer of the present invention is essentially soluble or dispersible in nature. Some of the many types of soluble or dispersible polymers which can be used in the method of the invention are listed below;
I. Polymerization Method
   Addition polymers
   Condensation polymers
II. By Physical characteristics
   Hydrolizable polymers
   Crosslinkable polymers
   Thermoplastic polymers
   Ionizable polymers
   Thermoset polymers
   Elastomers
III. By chemical composition
   Polycarbonates
   Polyimides
   Polyesters
   Olefin copolymers
   Polyacrylates (including methacrylates)
   Polystyrene
   Phenoxy resins
   Phenol - formaldehyde resins
   Cellulosic polymers
   Poly (vinyl acetate)
   Poly (vinyl butyral)
   Poly (vinyl chloride)
   Poly (vinyl chloride acetate)

The preferred polymer, suited for aqueous processability and results in high resolution contains a copolymer or interpolymer of a C₁-C₁₀ alkyl acrylate, C₁-C₁₀ methacrylate, or substituted or unsubstituted styrene, and an ethylenically unsaturated carboxylic acid containing moiety which is at least 15% by weight of the total polymer weight. A preferred substituted styrene is alpha methyl styrene. Suitable copolymerizable carboxylic acids include ethylenically unsaturated monocarboxylic acids such as acrylic, methacrylic and crotonic acids and ethylenically unsaturated dicarboxylic acids such as fumaric, itaconic, citraconic, vinyl succinic and maleic acids as well as their half esters and, where appropriate, their anhydrides and mixtures thereof. Because they are cleaner burning in low-oxygen atmospheres, methacrylic polymers such as methyl or isobutyl methacrylates are preferred over acrylic polymers. The most preferred polymer is a methyl methacrylate with = 20-25% substitution of methacrylic acid. Typical atomic weight is 400-450.

Polymers can be made by those skilled in the art of acrylate polymerization by conventional soluticn polymerization techniques. Typically acidic acrylate polymers are prepared by combining an alpha, beta-ethylenically unsaturated acid with one or more copolymerizable monomers in a relatively low boiling (75°-150°C) organic solvent to obtain a 10 to 60% solution of the monomer mixture, then subsequently causing the monomers to polymerize by the addition of a polymerization catalyst such as organic peroxide and heating the mixture at the reflux temperature of the solution at atmospheric pressure. After the polymerization reaction is essentially complete, the resulting carboxylic acid co-polymer solution is cooled to room temperature and samples are removed to determine the viscosity, molecular weight, acid equivalent, etc. of the polymer.

Suitable acid labile polymers include 1) polymers having acrylic, vinyl, polyester and polyurethane backbones and pendant acid labile carboxylic esters such as alpha-alkoxy alkyl esters, secondary or tertiary alkyl esters, silyl esters or pendant acid labile esters of other acids such as sulfonic acid, sulfinic acid, and phosphonic acid; 2) polymers in which the backbone is acid labile such as the polymers described in Polymeric Material Science And Engineering, 60, p. 170-178, 1989; and 3) polymers which are crosslinked with acid labile groups such as the polymers disclosed by Reiser et al., U.S. Serial No. 07,421,546 (filed October 13, 1989). Polymers which are crosslinked with acid labile groups may also have additional acid labile groups.

A second polymer may be utilized in the composition. The second polymer is not necessarily acid containing or acrylate. It modifies rheology of the composition which enhances diffusion of the solubilizing agent (triethanolamine) in the patterning ink. It helps control any plasticizer expressed in the tape during lamination. The preferred second polymers are ethyl cellulose or high molecular weight methyl methacrylate.

### E. Plasticizers

Both the unpatterned tape layer and the patterned layer preferably contain a substantial amount of plasticizer in which the polymer component of the unpatterned tape layer is substantially soluble. The primary function of the plasticizer in both layers is to facilitate diffusion of an alkaline or acid sensitizer from the patterning layer into the underlying areas of the unpatterned tapelayer and to enhance laminatability. While it is not absolutely necessary to have plasticizer in both layers, it is nevertheless preferred because it gives greater imaging sensitivity. The plasticizers in the two layers may be the same or different so long as they meet the particular criteria for both layers. The plasticizer in the upper patterned layer must be capable of dissolving the polymer in the unpatterned layer. It may optionally be capable of forming a solid two-phase system with the polymer in the unpatterned layer. On the other hand, the plasticizer in the patterned layer must be a solvent for the binder polymer in the patterned layer, for the polymer in the unpatterned layer, and for the organic acidic or basic sensitizer. The amount of plasticizer used in the layers varies widely depending upon the polymer which is used. As will be described later, it is preferred to maximize the amount of plasticizer in the unpatterned layer to minimize the amount of polymer which must be burned off when the layers are fired in the tunnel kiln. It is preferred that the boiling points of the plasticizers be at least 300°C at 1 ATM. Nevertheless, it is further preferred that the volatility of the plasticizers be such that they can be removed from the system by simple heating if it is desired to reduce the amount of plasticizer. In fact this technique may in some instances be preferred since the removal of plasticizer in this manner leaves openings in the unpatterned tape that facilitate escape of gaseous burnout products from the patterned layer.

A wide range of plasticizers can be used to facilitate the penetration of the acidic or basic sensitizer into the polymer tape that is to be patterned and to adjust the film properties. A plasticizer should be selected which shows reasonable compatibility with the binder and other components of the layers. With acrylic binder, for example, plasticizers can include dibutyl phthalate and other esters of aromatic acids; esters of aliphatic polyacids such as diisoctyl adipate, aromatic or aliphatic acid esters of glycols, polyoxyalkylene glycols, aliphatic polyols; alkyl and aryl phosphates; chlorinated paraffins; and sulfonamide types can be used.

In general, water insoluble plasticizers are advantageous for greater high humidity storage stability and environmental operating latitude, but are not required. Suitable plasticizers include: glycol, triethylene glycol diacetate, triethylene glycol dipropionate, triethylene glycol dicaprylate, triethylene glycol dimethyl ether, triethylene glycol bis(2-ethylhexanoate), tetraethylene glycol diheptanoate, poly(ethylene glycol), poly(ethylene glycol) methyl ether, isopropyl naphthalene, diisopropyl naphthalene, poly(propylene glycol), glyceryl tributyrate, diethyl adipate, diethyl sebacate, dibutyl suberate, tributyl phosphate, tris(2-ethythexyl) phosphate, t-butylphenyl diphenyl phosphate, triacetin, dioctyl phthalate, C₁₂H₂₅(OCH₂CH₂)₂₀OH, tris(2-butoxyethyl) phosphate and phthalates such as dicyclohexyl phthalate, dioctyl pathalate, diphenyl phthalate, diundecyl phthalate, butyl benzyl phthalate, 2-ethylhexyl benzyl phthalate.

Suitable acid labile plasticizers include compounds containing acid labile esters of carboxylic acid, sulfonic acid, sulfonic acid, and phthalic acid. Preferred acid labile groups are esters of carboxylic acid, represented by the formula:

-CO₂-C(R¹)(OR²)-CH(R³)(R⁴),

wherein
R¹ is hydrogen or alkyl;
R² is alkyl; and
R³ and R⁴ are each independently hydrogen or alkyl and R¹ and R², R¹ and either R³ or R⁴ when taken together form a 5-, 6- or 7-membered ring.

The more preferred plasticizer is bis(tetrahydropyranyl) phthalate.

The organic solids are formulated so that as much plasticizer as possible is used in the resin/plasticizer mixture. The reasons are twofold. First, the depth of penetration of the DP patterning ink is inversely proportional to the amount of resin in the vehicle, since the resin progressively neutralizes and slows down the patterning ink as it diffuses in. With less resin, the DP ink will diffuse deeper, allowing a deeper via to be patterned. The second reason is that the resin must be burned out in the furnace, whereas the plasticizer can be evaporated. A ratio of approximately 1 part by weight of total resin to two parts by weight of plasticizer has been found to be satisfactory both in screen printed DP dielectrics and in DP TOS. The examples have approximately a ratio of resin to plasticizer of 2.5 to 1. Ratios of 1:1 will laminate well but will not afford an optimum depth of penetration of the patterning ink.

### F. Organic Acid used as Sensitizer for Acid Labile Resins

The deprotection reactions of the acid labile polymer are initiated with a catalytic amount of acid. The deprotected compounds become ionized in aqueous solution, such as aqueous alkaline solution, and render the composition soluble. Useful acids for this purpose include trifluoroacetic acid, oxalic acid, p-toluenesulfonic acid, trifluoromethanesulfonic acid, p-nitrobenzenesulfonic acid, and the like.

It is preferred that the acid component of the patterning layer be an organic acid. Either liquid acids, low melting acids or acid solutions may be use. If a plasticizer is used in the patterning layer, it is preferred that the acid and plasticizer be mutually soluble.

When acid labile resin is used, the amount of acid in the patterning over-print paste or ink must be sufficient to provide a catalytic amount for the deprotection reaction by diffusion to the underlying first layer. Although depending on the application method and the formulation of the carriers and the catalytic efficiency of the acid with respect to the acid-labile compound, the patterning layer may contain merely a fraction of 1% by weight of acid or it may contain as much as 90% by weight of acid.

While inorganic acids can be used in practicing the invention, they are not preferred because of environmental and safety considerations. Moreover, they present problems of corrosion with the equipment for their application which are not associated with most organic acids.

### G. Organic Base used as Sensitizer for Acidic Resins

The organic base used as sensitizer for the acidic resin must be soluble in the resin/plasticizer used both in the bottom tape layer as well in the overprinted patterning layer. It must be sufficiently alkaline to ionize the -COOH moieties in the resin, and be sufficiently water soluble that the patterned areas may be washed off by the aqueous wash step.

### H. Solid Components

The solids component of the unpatterned layer will often be a dielectric material, such as glass or a mixture of glass-forming oxides, which will densify and/or sinter when they are fired at, for example, 850°C. The chemical composition of the solids is not by itself important with respect to application of the invention so long as the material is inert to the components of the organic medium. The method of the invention can, of course, be used to pattern polymeric thick film layers which are not fired.

The use of solids in the patterned layer is not always necessary. Nevertheless, the use of finely divided solids is a very, useful way of obtaining appropriate rheological properties of the layer for printing and subsequent processing in accordance with the invention. The composition of the solids in the patterned layer is not otherwise important since they are physically removed from the system by washing after completion of the diffusion patterning step.

The particle size of the solids is also not critical. However, it should ordinarily be in the range of 0.5-20 microns.

The thick film tape can also contain a large variety of conductive materials including Au, Ag, Pd, Cu, Ni, and alloys and mixtures thereof. The particle size of the condutive metal particles should be within the range of 0.1-20 micrometers and preferably 0.5-10 micrometers.

### I. Patterned Layer Polymer

The primary function of polymers in the patterning layer is to adjust the rheology of the layer consistent with the way it is applied to the unpatterned layer. Therefore, it is not an essential component of the patterned layer in every instance. For example, it is not needed when the layer is applied by ink-jet,printing. However, when the patterning layer is applied as a thick film paste, the polymer serves both to adjust the rheology of the paste and as a binder for the finely divided solids until they are removed in the washing step.

The nature of the binder polymer is not critical within broad limits so long as the rheological properties of the patterning layer are appropriate for the method of application. However, when the patterned layer is applied as a thick film paste, it is strongly preferred to use cellulosic polymers such an ethyl cellulose as the binder because of its very desirable thixotropic properties. The solvent system is formulated so that the diffused patterned areas can be removed by an aqueous wash or spray.

### J. Aqueous Base Solution

The diffusion patterned areas of tapes with acid-labile polymer need to be dispersed with an aqueous base solution. To obtain satisfactory removal of the solubilized polymer and residual amounts of acid from the layers, the pH of the aqueous base washing solution should be preferably at least 9 depending on the nature of the acid labile polymer. For example, polyacrylic acid is soluble in water while copolymers of benzyl methacrylate and acrylate and would require a higher pH for dissolution. Optionally, low levels of water soluble surfactants may be present in the wash solution to facilitate the interaction between the acid and the polymer film when an acid labile resin is used in the composition.

### K. Formulation and Application

The method of the invention is intended primarily for use in making functional layers in the fabrication of electronic components. Typically the patterned layer which contains a dispersibility changing agent (in this case organic acid or base) will range from 5 to 30 microns thickness while the unpatterned layer can be of much greater thickness, from 10 to 100 microns. The thickness of the patterned layer is usually limited by desired resolution and the method of application, rather than by considerations of operability.

The following generalization estimates the optimum level of the various components for practicing the diffusion patterning technology successfully with dielectrics of the type (multilayer) illustrated in this application. To optimize lamination, patternability, burnout properties, and fired film integrity, the following volume relationships have been found to be advantageous. They will be converted into weight percentages to illustrate typical formulation recipes. The inorganic phase will be assumed to have a specific gravity of 3.9 and the vehicle will be assumed to have a specific gravity of 1.3.

| TAPE | | |
|---|---|---|
| | Volume % | Weight % |
| | | |
| Inorganic phase | 40 to 60% | 67 to 82% |
| | 50% preferred | 75% preferred |
| | | |
| Non-volatile | 60 to 40% | 33 to 18% |
| Organic Phase | 50% preferred | 25% preferred |

Since the tape is usually cast from slip (see Examples 1), the recipe for the slip must include solvent sufficient to lower the viscosity of the castable slip to under 10 Pascal-seconds; typical viscosity ranges are 0.3 to 6 Pascal-seconds. Additionally, since some types of polymer and metal oxide dispersion will not be viscosity stable due to interactions between soluble oxides and the resin, care must be taken where appropriate to passivate the reactive inorganic species, either by removing water from the slip (see Example 1), removing surface ions by leaching with hot water or acid or base, or, in the event of an extremely reactive component, by adding an inert coating to the surface of the reactive intermediate. Since acid labile resins' reactive groups are more protected, they may be expected to be significantly less reactive than straight acid containing resins. Removal of water from the vehicle as in Example 1, together with removal of adsorbed water by heating the inorganic phase, is often sufficient to stabilize the slip for one or two weeks storage before casting. Due to the high viscosity of the cast tape, tapes are usually stable once cast.

| SLIP | | |
|---|---|---|
| | Volume % | Weight % |
| | | |
| Inorganic Phase | 35-15% Preferred | 58-30% Preferred |
| | | |
| Non-volatile | 35-15% Preferred | 32-20% Preferred |
| Organic phase | | |
| | | |
| Volatile Solvent | 30-70% Preferred | 10-50% Preferred |

The above values of the slip are guidelines that include the more likely range of inorganic solids, organic solids, and solvents that are apt to be encountered in actual formulations. If an extremely heavy solids such as gold powder (spec. grav. = 19 . 4) is used, the inorganic phase weight fraction must be higher. The above range is most useful for inorganic phases such as dielectrics, resistors, lighter metals such as copper or silver, or a solids phase with specific gravity under 7 and over 3. The particle size of the inorganic phase is also a determinant of solids loading. In general the finer the particle size the greater the organic solids fraction necessary for a DP tape. Also, by mixing particle sizes, often a higher inorganic solids fraction is made possible than by using a single particle size. The optimum solvent for slips using the resins in the example is ethyl methyl ketone, or a mixture of ethyl acetate with ethyl methyl ketone or acetone, typically 90/10 ethyl acetate/MEK or acetone.

In addition, the composition of the slip results in a solvent-free polymer plasticizer dispersion which is specularly nonreflective. It is theorized that if a polymer is not smooth and glossy, a second phase is present which disrupts the smoothness of the film. In the present invention it is not necessary that a true solution be achieved for DP of the resulting film. In fact, the existence of a second, plasticizer rich phase is postulated because of the fact that the appearance of the film changes with the addition of a second polymer. The alkaline printing ink appears to penetrate more readily into a polymer film that has a second phase versus a single phase film. The two polymers used in Example 1 are in fact incompatible in most proportions.

### L. Alternate Patterning Systems

There are many alternate material systems which can use the selective solubilization principle to generate thick film patterns. The pattern may be positive or negative working, i.e., the area under the overprint may either be solubilized, as in Examples 1, 2, and 3 that follow, or it may be insolubilized, for example by overprinting an aqueously developable polymer with a water incompatible plasticizer to protect the areas underneath, then removing the unplasticizer material by aqueous solubilization. The following Table illustrates a number of approaches to formulating materials systems by the permeation method.

| **Underprint Resin** | **Overprint Solubilizer (Negative)** | **Overprint Desolubilizer (Positive)** | **Patterning Solvent** |
|---|---|---|---|
| | | | |
| Polymethylmethacrylate | *Dibutyl Phthalate | | Methyl Chloroform |
| Polymethylacrylate | *Butyl Benzyl-Phthalate | | |
| | *Ethylhydroxyethyl cellulose | | |
| | | | |
| Polyethylmethacrylate | *Triethylene- | | Methanol |
| | Glycol | | Ethanol |
| Polyethylacrylate | | | Freon MF |
| | | | Freon TF |
| | | | |
| | | Polymethylmethacrylate | Ethanol/water/ammonia |
| | | | |
| Polybutylmethacrylate | *Triethylene | | Ethanol |
| Polybutylacrylate | Glycol | | |
| | | | |
| Carboset® 1234 | *Triethanol-amine | | Water |
| | *NaCO₃ | | |
| | | Dibutyl | K₂CO₃/Water |
| | | Phthalate | |

The above resins may be combined, for example, methyl and ethyl methacrylate, to allow positive or negative working resists. In the case of methyl methacrylate/ethyl methacrylate combinations, plasticizers such as triethylene glycol would produce a negative working resistor in ethanol pattern generating solvent.

Other resin systems that are not excessively crosslinked, such as polyesters, may be patterned in a similar manner. One merely needs to determine a solubilizer or desolubilizer and a suitable pattern generating solvent.

If no solubility envelope exists for a highly crosslinked polymer, that polymer would not be a likely candidate for the process.

The invention will be further illustrated by the following examples:

### EXAMPLES

### EXAMPLE 1

Tape compositions consist of dielectric solids, a resin capable of being ionized and made water soluble by an alkaline ink, a plasticizer to increase the rate of penetration of the alkaline sensitizer, and preferably, a second resin that need not be ionizable, to increase the viscosity of the plasticizer rich second phase that is desirable in diffusion patternable films to further enhance diffusion of the alkaline sensitizer of the patterning layer into the unpaterned first layer tape. The formula follows:

| | (grams) |
|---|---|
| Dielectric Solids (Table 1) | 200 |
| | |
| Organic Vehicle (Table 3) | 180 |
| | |
| Trixotrope | 1.60 |

**TABLE 1**

| | Amount (wt.%) |
|---|---|
| Glass A (Table 2) | 31.51 |
| Glass B (Table 2) | 47.41 |
| Alumina | 6.56 |
| Calcium Zirconate | 8.76 |
| Cobalt Aluminate | 3.00 |
| Titanium Oxide | 2.62 |

**TABLE 2**

| | Glass A (wt.%) | Glass B (wt.%) |
|---|---|---|
| BaO | 12.56 | 11.78 |
| SrO | 10.82 | 10.15 |
| CaO | 6.70 | - |
| ZnO | 16.00 | 21.29 |
| Al₂O₃ | 5.50 | 6.90 |
| SiO₂ | 46.01 | 47.64 |
| ZrO₂ | | |

**TABLE 3**

| | Amount (wt.%) |
|---|---|
| Acidic Resin A | 13.5 |
| XPD 1034 | 33 |
| XPD 1708 | 67 |
| Resin B | 0.9 |
| Plasticizer C | 25.0 |
| Methyl Ethyl Ketone | 60.7 |

**TABLE 4**

| | Amount (grams) |
|---|---|
| Alumina | 60 |
| Vehicle | 40 |
| B.F. Goodrich XPD 1234 | 8.33 |
| Elvacite 2051 | 0.3 |
| Triethanolamine | 33 |
| Terpineol | 15 |
| Butyl Benzyl Phthalate | 17.7 |

Glass A & B: Glass particle size is 4 to 5 microns average diameter equivalent. These glasses are moisture sensitive with relatively large psd to minimize the surface areas.

Resin A: B.F. Goodrich XPD 1034, ∼35,000 MW, ∼20% free acid, polymethylmethacrylate/methacrylic acid copolymer. B.F. Goodrich XPD 1708, copolymer of methylmethacrylate/methacrylic acid, ∼7,000 MW, ∼20% free acid.

Resin B: Hercules ethyl Cellulose, grade T-200, used commonly in thick film pastes; ethoxyl substitution of 48-50%, soluble in common solvents, viscosity of 200 in ethanol/toluene.

Plasticizer C: Butyl Benzyl Phthalate; e.g., Monsanto "Santicizer(tm) S-160".

Thixotrope: Microcrystals of hydrogenated castor oil (25%) in a hydrocarbon/glycol ether vehicle. Commercially supplied by Bake MPA-60.

B. F. Goodrich XPD 1234 (Carboset®) - is a copolymer of methacrylic acid and methyl methacrylate with 25% methacrylic acid units and a molecular weight of ∼7000. Tg is about 100°C.

The vehicle was prepared by dispersing the resins in the solvent, according to techniques known to those skilled in the art. The paste was roll milled as a typical thick film paste to produce a good dispersion.

Vehicle preparation poses a problem because the resin contains several percent moisture. The moisture was sufficient to cause surface divalent ions to leach off of glasses and oxides. These divalent ions then cross linked with carboxyl groups on the polymer and caused severe viscosity drift, so that it was impossible to cast the tape with the unstable slip. The preheating step to 110 degrees described below serves to drive moisture out of the resin at high temperature before adding the volatile solvent, which would evaporate rapidly if it were present at the higher temperature. The vehicle preparation was carried out in a resin kettle with stirring by air motor. The resins A and B were heated together with plasticizer C to 110 degrees for 30 minutes. The mixture was then cooled to 40 degrees as rapidly as possible, after which the solvent methyl ethyl ketone was added. The mixture was stirred at 40 degrees using a resin kettle with a reflux condenser until a clear solution was achieved. To exclude moisture the kettle was padded with nitrogen during resin dissolution.

The solids were also pretreated to remove moisture by heating at 450 degrees C for 4 hours, then cooling to room temperature before adding to the vehicle. The moisture removal greatly enhanced the viscosity stability of the slip. The solids were weighed into a 1 quart jar mill with an appropriate volume of grinding media, along with the thixotrope and vehicle. The mixture was rolled in jar mill at 60rpm for 3 hours.

After milling, the material was filtered through fine mesh, and allowed to roll slowly for at least an hour and preferably overnight before casting using a 14 mil knife on silicone treated Mylar. A dielectric tape approximately 100 microns in thickness was produced.

The tape is laminated in a roll laminator using spring loading on the rolls, at a temperature of 125 degrees. After roll laminating, annealed for 1 hour in an oven at 100 degrees C which improves tape adhesion to substrates. The coversheet was then stripped, and a patterning layer (Formula in Table 4) was deposited on top of the tape. Oven heating at 70 to 90 degrees for 10 to 20 minutes sufficed to diffuse the alkaline solubilizer into the tape. Washing in water then generated vias. The patterned tape was then fired at 850 degrees at 30 and 60 minute firing profile, using ten minutes at peak temperature.
The use of the second resin is intended to thicken the slip to improve castability; also it may be used to thicken a second phase which can exist as a minor fraction of the organic portion of the tape which is low viscosity and is squeezed out of the film under laminating conditions of high pressure and temperature. It is theorized that the secondary resin may concentrate in the plasticizer-rich phase and increase its viscosity to prevent loss of secondary phase during lamination. It also enhances the laminatability of the tape to the substrate by keeping the plasticizer rich phase from interfering with the bonding between the resin rich phase and the substrate.

### EXAMPLE 2

The chemical composition of Example 2 is identical to Example 1. However, the processing is different, the object of the variation being to reduce the attrition of the relatively soft glasses, while providing more milling time for the oxide powders in the dielectric solids.

The vehicle preparation is carried out in a resin kettle with stirring by air motor. The resins A and B are heated together with plasticizer C to 110 degrees for 30 minutes. The mixture is then cooled to 40 degrees as rapidly as possible, after which the solvent methyl ethyl ketone is added. The mixture is stirred at 40 degrees using a resin kettle with reflux condenser until a clear solution is achieved. The rationale for this process is the same as in Example 1: to remove moisture from the resin.

The oxides were preheated as in Example 1, then weighed into a 1 quart jar mill with an appropriate volume of grinding media, along with the thixotrope and vehicle. The mixture was rolled in jar mill at 60 rpm for 4 hours. In order to reduce the amount of fresh surface on the glass, the relatively soft glass is not introduced until after the oxides have been milled for four hours. The glasses were then added, and the slip was milled an additional four hours. Excessive grinding of the glasses causes the slip to become viscosity unstable because of their high content of divalent metal ions, which causes viscosity drift, as discussed in Example 1.

After milling, the material was filtered through fine mesh, and allowed to roll slowly for at least an hour and preferably overnight before casting using a 14 mil knife on silicone treated Mylar®. A dielectric tape approximately 100 to 190 micron thickness is produced, depending on the amount of pressure on the slip at the knife edge.

The tape is laminated in a roll laminator using spring loading on the rolls, at a temperature of 125 degrees. After roll laminating, annealing for 1 hour in an oven at 100 degrees improves tape adhesion to the substrate. The coversheet (Mylar®) was then stripped, and a diffusion patterning patterned print was deposited on top of the tape. Oven heating at 70 to 90 degrees for 10 to 20 minutes suffices to diffuse the alkaline solubilizer into the tape. Washing in water then generates vias. The patterned tape was then fired at 850 degrees in either a 30 or 60 minute firing profile, using ten minutes at peak temperature.

### EXAMPLE 3

This tape composition consists of the dielectric solids, a resin mixture capable of being ionized and made water soluble by an alkaline ink, a plasticizer to increase the rate of penetration of the alkaline sensitizer, and preferably, a second resin that need not be ionizable, to increase the viscosity of the plasticizer rich second phase that is desirable in diffusion patternable films to further enhance diffusion of the alkaline sensitizer into the dielectric films. The formula follows :

| | (grams) |
|---|---|
| | |
| Dielectric Solids | 200 |
| | |
| Organic Vehicle (Table 5) | 180 |
| | |
| Thixotrope | 1.60 |

**TABLE 5**

| | Amount (wt.%) |
|---|---|
| Acidic Resin A | 14.4% |
| XPD1034 | 33% |
| XPD1708 | 67% |
| Plasticizer C | 25.0% |
| Methyl Ethyl Ketone | 60.7% |

The components of the formulation are described in Example 1.

Vehicle preparation posed a problem because the resin contained several percent moisture. This moisture is sufficient to cause surface divalent ions to leach off of glasses and oxides. These divalent ions will cross link with carboxyl groups on the polymer and cause severe viscosity drift, so that it is impossible to cast the tape with the unstable slip. The preheating to 110 degrees described below serves to drive moisture out of the resin at high temperatures before adding the volatile solvent, which would evaporate rapidly if it were present at the higher temperature. The vehicle preparation was carried out in a resin kettle with stirring by air motor. The resins were heated together with plasticizer C to 110 degrees for 30 minutes. The mixture was then cooled to 40 degrees as rapidly as possible, after which the solvent methyl ethyl ketone was added. The mixture was stirred at 40 degrees using a resin kettle with a reflux condenser until a clear solution is achieved. To exclude moisture the kettle was padded with nitrogen during resin dissolution.

The solids were also pretreated to remove moisture by heating at 450 degrees C for 4 hours, then cooling to room temperature before adding to vehicle. The moisture step greatly enhanced the viscosity stability of the slip. The solids were weighed into a 1 quart jar mill with an appropriate volume of grinding media, along with the thixotrope and vehicle. The mixture was rolled in a jar mill at 60 rpm for 3 hours.

After milling, the material was filtered through fine mesh, and allowed to roll slowly for at least an hour and preferably overnight before casting using a 14 mil knife on silicone treated Mylar®. A dielectric tape approximately 100 microns in thickness was produced.

The tape was laminated in a roll laminator using spring loading on the rolls, at a temperature of 125 degrees. After roll laminating, laminated parts annealed for 1 hour in an oven at 100 degrees C improved tape adhesion to the substrate. The coversheet was stripped, and a patterned layer is deposited on top of the tape. Oven heating at 70 to 90 degrees for 10 to 20 minutes sufficed to diffuse the alkaline solubilizer into the tape. Washing in water then generates vias. The patterned tape was fired at 850 degrees at 30 and 60 minute firing profile, using ten minutes at peak temperature.

### EXAMPLE 4

The chemical composition of Example 4 differs from the others in that it contains only a single resin. The composition follows:

| | (grams) |
|---|---|
| | |
| Dielectric Solids | 200 |
| | |
| Organic Vehicle (Table 6) | 180 |
| | |
| Thixotrope | 1.60 |

**TABLE 6**

| | Amount (wt.%) |
|---|---|
| Acidic Resin A | 13.5% |
| XPD1034 | 100% |
| Plasticizer C | 25.0% |
| Methyl Ethyl Ketone | 60.7% |

The components of the formulation are described in Example 1.

The vehicle preparation was carried out in a resin kettle with stirring by air motor. The resin was heated together with plasticizer C to 110 degrees for 30 minutes. The mixture was cooled to 40 degrees as rapidly as possible, after which the solvent methyl ethyl ketone was added. The mixture was stirred at 40 degrees using a resin kettle with reflux condenser until a clear solution was achieved. This was carried out to remove moisture from the resin.

The oxides were preheated in Example 1, then weighed into a 1 quart jar mill with an appropriate volume of grinding media, along with the thixotrope and vehicle. The mixture was rolled in a jar mill at 60 rpm for 4 hours. In order to reduce the amount of fresh surface on the glass, the relatively soft glass was not introduced until after the oxides have been milled for four hours. The glasses were then added, and the slip was milled an additional four hours.

After milling, the material was filtered through fine mesh, and allowed to roll slowly for at least an hour and preferably overnight before casting using a 14 mil knife on the silicone treated Mylar®. A dielectric tape approximately 100 to 190 micron thickness was produced, depending on the amount of pressure on the slip at the knife edge.

The tape was laminated in a roll laminator using spring loading on the rolls, at a temperature of 125 degrees. After roll laminating, annealed for 1 hour in an oven at 100 degrees C improved tape adhesion to substrates. The coversheet was then stripped, and a patterning layer was deposited on top of the tape. Oven heating at 70 to 90 degrees for 10 to 20 minutes sufficed to diffuse the alkaline solubilizer into the tape. Washing in water then generated vias. The patterned tape was then fired at 850 degrees in either a 30 or 60 minute firing profile, using ten minutes at peak temperature.

### EXAMPLE 5

Two compositions are formulated: one a dielectric tape, and one a patterning paste. Neither the resin nor the dielectric solids in this Example are moisture sensitive, as was the case in Examples 1-4, so no particular precautions are taken to avoid excessive moisture in the composition. The compositicn follows:

### Dielectric Tape

| | (wt.%) |
|---|---|
| Glass C (Table 7) | 30.0% |
| Glass D (Table 7) | 1.6 |
| Alumina A | 15.0 |
| Alumina B | 6.2 |
| Cobalt Aluminate | 0.15 |
| Polymethyl methacrylate | 10.2% |
| Wetting agent | 2.3 |
| t-butylanthraquinone | 1.00 |
| Butylhydroxytoluene | 0.05 |
| Ethyl Acetate | 26.6 |
| Ethyl methyl ketone | 5.5 |
| Butyl Benzyl Phthalate | 1.4 |

**TABLE 7**

| | Glass C (wt.%) | Glass D (wt.%) |
|---|---|---|
| SiO₂ | 56.2 | 16.5 |
| PbO | 18.0 | |
| Al₂O₃ | 8.6 | |
| CaO | 7.4 | |
| B₂O₃ | 4.5 | 38.3 |
| Na₂O | 2.7 | |
| K₂O | 1.6 | |
| MgO | 0.8 | 4.3 |
| ZrO₂ | 0.2 | 3.0 |
| BaO | | 37.5 |

Glass C has a D₅₀ of ∼4 to 4.5 microns; it is milled and classified to remove coarse and fine fractions. Its D₁₀ is about 1.6 microns; its D₉₀ is 10-12 microns, surface area is 1.5 to 1.8 m²/g.

Glass D is a calcium tin borosilicate glass used to lower the sintering temperature of the dielectric composite, due to the large particle size of glass C.

Alumina A is a 1 micron powder with a narrow PSD: D₁₀, D₅₀, and D₉₀ are, respectively, ∼0.5, 1.1, and 2.7 microns. It is classified by settling to remove coarses and fines. Surface area is about 2.7-2.8 m²/g.

Alumina B is a 0.4 micron average PS powder with surface area of about 5 m²/g.

### Patterning Paste

| | (grams) |
|---|---|
| Alumina A | 60.0 |
| Hydrogenated Castor Oil | 1.4 |
| Mineral Spirtis | 4.0 |
| Colorant | 2.2 |
| Ethyl Cellulose T-200 | 4.3 |
| Ethyl acetate | 11.9 |
| Ethyl methyl ketone | 2.1 |
| Butyl Benzyl Phthalate | 16.2 |

The above compositions are prepared in a manner familiar to those skilled in formulation of thick film materials, and prepared for lamination. As in Example 1-4.

The patterning layer is then printed by using a via fill screen with several sizes of via openings. The patterning paste was then dried at 80 to 90 degrees C for 5 to 10 minutes.

The pattern is then generated in the dielectric by immersing the overprinted layers in chlorothene with ultrasonic agitation until the overprinted areas were removed and the areas under the overprinted patterning paste are dissolved away.

Vias as small as 4-5 mils are resolved in dielectric films as thick as 85 microns, with good edge definition.

### EXAMPLE 6

The conductor tape was formulated with copper powder, as follows:

| | (grams) |
|---|---|
| Copper powder, 3-4 micron | 73.0 |
| Glass Powder E | 5.0 |
| Poly methyl methacrylate | 6.1 |
| t-butylanthraquinone | 0.6 |
| t-butylhydroxytoluene | 0.1 |
| Ethyl Acetate | 15.2 |
| Ethyl methyl ketone | 2.6 |

### Glass Powder E

| | (wt.%) |
|---|---|
| Bi₂O₃ | 82.0% |
| PbO | 11.0 |
| B₂O₃ | 3.5 |
| SiO₂ | 3.5 |

The above copper tape was prepared from the above ingredients by techniques familiar to those skilled in thick film tape preparation.

One coat of the conductor composition was laminated onto alumina substrates; a negative of a screen printed conductor pattern was printed on top of the copper print, using the Patterning paste in Example 1. Both prints were dried at 85-95 degrees C. Dried parts were immersed in chlorothene with ultrasound agitation for 15-25 seconds to generate the desired pattern. Parts were then fired. Precise four mil line/space patterns were generated. Fired parts were 10-12 microns thick, with a resistivity of about 3 milliohms/square. Results in four mil lines/space resolution are difficult, if not impossible, to achieve, in a pattern with 3 milliohms/square. In addition, the topography of the 4 mil lines were superior to screen printed parts, with more precise edge definition, and flat surfaces on the tops of conductor fingers.

### EXAMPLE 7

A gold conductor tape with similar conductivity and thickness to the copper conductor of example 6 is formulated using techniques familiar to those in the art. The composition follows:

| | (grams) |
|---|---|
| Gold Powder | 72.0 |
| Copper Bismuthate | 1.5 |
| Polymethylmethyacrylate | 3.1 |
| t-butylanthraquinone | 0.3 |
| Ethyl Acetate | 10.4 |
| Ethyl methyl ketone | 2.7 |
| Butylhydroxytoluene | 0.1 |

The above composition is coated on a smooth tape substrate. The gold composition is laminated with a single coat onto an alumina substrate, and dried at 85-95 degrees. The patterning paste is then overprinted by screen printing with a negative of a thick film conductor pattern, and dried again at 85-95 degrees C.

The pattern is then generated by immersing the part into chlorothene that is ultrasonically agitated for 10 to 20 seconds. The resulting pattern is then fired at high temperature in a manner familiar to persons skilled in thick film art. A highly conductive gold pattern will result.

### _{EXAMPLE 8}

This positive working conductor paste system is formulated in copper, as follows:

### Copper Positive Working Tape

| | (grams) |
|---|---|
| Copper powder, 3-4 micron | 83.0 |
| Glass Powder E (Ex. 6) | 2.0 |
| Carboset® 1234 Resin | 3.2 |
| Benzotriazole | 0.3 |
| Ethyl Acetate | 9.5 |
| Ethyl methyl ketone | 2.0 |

### Copper Patterning Paste

| | (grams) |
|---|---|
| Copper powder, 3-4 micron | 46.00 |
| Glass Powder C | 1.25 |
| Ethyl Cellulose T-50 | 0.75 |
| Santicizer® S-160 | 2.83 |
| Terpineol Isomers | 2.29 |

The copper tapes are prepared from the above ingredients by techniques familiar to those skilled in thick film tape preparation, using similar techniques to those used in the first Examples. The patterning paste is prepared using techniques familiar to those skilled in thick film paste preparation.

One coat of the conductor composition is laminated onto alumina substrates; a negative of a screen printed conductor pattern is then printed on top of the copper print, using the Patterning paste in this Example. Both prints are dried at 85-95 degrees C. Dried parts are then immersed in a 1% potassium carbonate aqueous solution with ultrasound agitation for 5-15 seconds to generate the desired pattern. Precise four mil line/space patterns are generated. Dried parts are about two mils thick. The quality of the diffusion patterned conductor traces is very high. The quality of the 4 mil lines will be superior to screen printed parts, with more precise edge definition.

## Claims

1. A method for making patterns in organic polymer layers comprising the sequential steps:
A. Applying by lamination to a substrate an unpatterned first layer comprising a polymeric tape;
B. Applying to the unpatterned first layer a patterned second layer comprising a liquid solution consisting of organic acid or base and plasticizer;
C. Heating the patterned second layer to effect penetration of the organic acid or base and plasticizer into the underlying areas of the first layer whereby the polymeric film in the underlying areas of the first layer becomes solubilized by reaction with the organic acid or base; and
D. Washing the layers with water or an aqueous solution to remove the solubilized polymer from patterned areas of the first layer.

2. The method of claim 1 wherein the lamination is performed by roll or press.

3. The method of claim 1 in which the polymeric tape contains finely divided dielectric solids.

4. The method of claim 1 wherein the patterned second layer further comprises a volatile solvent.

5. A composition for use as the polymeric tape in the first unpatterned layer in a diffusion patterning process comprising:
A. a film-forming soluble or dispersible polymer;
B. a plasticizer in which the polymer is completely or partially soluble; and
C. volatile organic solvent.

6. The composition of claim 5 wherein the ratio of polymer to plasticizer being such that when the organic solvent is removed from the organic medium the resulting solvent-free polymer/plasticizer dispersion is specularly nonreflective.

7. The composition of claim 5 wherein a second polymer is ethyl cellulose.

8. The composition of claim 5 in which the polymer has a Tg of at least 100°C.

9. The composition of claim 5 further comprising finely divided particles of dielectric solids.
